Europäisches Patentamt

European Patent Office

Office européen des brevets

(19)

(11) Veröffentlichungsnummer: **0 255 644 B1**

(12)

# EUROPÄISCHE PATENTSCHRIFT

(45) Veröffentlichungstag der Patentschrift: **24.06.92**

(21) Anmeldenummer: **87110497.2**

(22) Anmeldetag: **20.07.87**

(51) Int. Cl.5: **B23K 35/30**, H01L 23/48, H01L 25/04

(54) Verfahren zur Herstellung eines Drucksensors.

(30) Priorität: **08.08.86 DE 3626804**

(43) Veröffentlichungstag der Anmeldung:
**10.02.88 Patentblatt 88/06**

(45) Bekanntmachung des Hinweises auf die
Patenterteilung:
**24.06.92 Patentblatt 92/26**

(84) Benannte Vertragsstaaten:
**DE FR GB IT NL**

(56) Entgegenhaltungen:
**DE-A- 1 527 435       FR-A- 1 450 719
GB-A- 1 026 858       GB-A- 1 556 397
US-A- 4 065 588       US-A- 4 123 293**

(73) Patentinhaber: **SIEMENS AKTIENGESELL-
SCHAFT
Wittelsbacherplatz 2
W-8000 München 2(DE)**

(72) Erfinder: **Hagen, Heinz, Dipl.-Ing.
Albrecht-Dürer-Strasse 32
W-8014 Neubiberg(DE)**
Erfinder: **Thurn, Herbert, Dr. rer. nat.
Rohrmühlstrasse 27
W-8591 Tröstau(DE)**
Erfinder: **Ehrler, Günter, Dipl.-Phys.
Linienstrasse 25a
W-8024 Deisenhofen(DE)**
Erfinder: **Reichert, Hansjörg, Dr., Dipl.-Phys.
Weissenseestrasse 83
W-8000 München 90(DE)**

EP 0 255 644 B1

## Beschreibung

Die Erfindung betrifft ein Verfahren nach dem Oberbegriff des Patentanspruchs 1 bzw. 10

Zur Herstellung eines Drucksensors muß eine Trägerscheibe aus Silicium mit einer Drucksensormembran-Scheibe verbunden werden. Bei der Herstellung von Drucksensoren ist es darüberhinaus erforderlich, die Drucksensormembranscheibe (Systemscheibe) mit der Trägerscheibe vakuumdicht zu verbinden.

Nach dem Stand der Technik erfolgt die Verbindung zweier Silizium-Scheiben entweder mit einem Kaltschweißverfahren, welches jedoch teuer und kompliziert ist. Zum Verbinden von Silizium-Scheiben ist auch eine Aluminium-Legiertechnik bekannt, bei der zwei Silizium-Scheiben mit Hilfe einer zwischen den beiden Silizium-Scheiben angeordneten Aluminiumschicht verbunden werden. Dabei muß Aluminium mit Silizium legiert werden, wofür eine Temperatur oberhalb der Aluminium-Silizium-Eutektikumstemperatur und damit von etwa 650 ° C erforderlich ist. Weil bei einer solchen Temperatur die bei einer komplett fertiggestellten Silizium-Systemscheibe vorhandenen üblicherweise verwendeten Leitbahnen durchlegieren würden und weil bei einer so hohen Temperatur aufgrund von Diffusionsvorgängen auch die in einer bereits fertiggestellten Silizium-Systemscheibe vorhandenen pn-Übergänge in nachteilhafterweise verändert werden würden, ist die Verwendung einer Aluminium-Legiertechnik zum Verbinden zweier Silizium-Scheiben miteinander ungünstig.

Aus US-A-4 123 293 ist ein Verfahren zum Verbinden einer Silizium-Scheibe mit einer Wärmesenke aus Kupfer bekannt. Dabei wird eine Goldfolie zwischen die Silizium-Scheibe und die Kupfer-Scheibe gelegt und auf eine Temperatur oberhalb der Gold-Silizium-Eutektikumstemperatur erhitzt.

Aus GB-A-1 556 397 ist ein Verfahren zur Herstellung von Halbleiterbauelementen hoher Leistung bekannt, bei dem eine Silizium-Scheibe mit einer anderen Silizium-Scheibe verbunden wird. Dabei wird eine Metallfolie aus Gold zwischen die beiden Silizium-Scheiben gelegt. Diese Goldfolie bildet eine Legierung mit Silizium.

Der vorliegenden Erfindung liegt die Aufgabe zugrunde, ein Verfahren der eingangs genannten Art anzugeben, bei dem es möglich ist, extrem gleichmäßige und reproduzierbare Verbindungen billig und in einfacher Weise herzustellen.

Diese Aufgabe wird erfindungsgemäß durch ein Verfahren nach dem Anspruch 1 bzw. 10 gelöst.

Durch die Gold-Legiertechnik wird die Verbindung von zwei Silizium-Wafern, gleichgültig welcher Größe, in der bei den Ausführungsbeispielen beschriebenen Weise kostengünstig auf technologisch vorteilhafte Weise gelöst. Der technologische Ablauf sowie vorteilhafte Randbedingungen werden nachfolgend für die Herstellung von Drucksensor-Meßzellen im Wafer-Verband dargestellt.

Die Erfindung ermöglicht die vakuumdichte Verbindung von zwei oder mehreren Träger- bzw. Drucksensormembranscheiben aus Silicium.

Eine Gold-Schicht ist vorteilhafterweise auf einer nichtpolierten, d. h. rauhen Silicium-Oberfläche auflegiert. Soll das Auflegieren einer Gold-Schicht auf eine Silicium-Scheibenoberfläche zunächst vermieden werden, so kann eine Gold-Schicht mit Hilfe einer haftvermittelnden Schicht beispielsweise aus Titan oder aus Nickel auf die Silicium-Scheibe aufgebracht werden.

Eine rauhe Silicium-Scheibenoberfläche ist für die Bildung eines Gold-Silicium-Eutektikums günstig. Um eine gleichmäßige Gold-Silicium-Eutektikumsphase zu erzeugen, soll die auf eine Silicium-Scheibe oder auf die mit der Silicium-Scheibe zu verbindende andere Scheibe aufgebrachte Gold-Schicht relativ dick sein. Ein solche Gold-Schicht kann vorteilhafterweise durch Aufbringen mehrerer dünnerer Gold-Schichten hintereinander erzeugt werden.

Vorteilhafterweise ist auf beiden miteinander zu verbindenden Scheiben jeweils eine Gold-Schicht vorhanden. Es genügt jedoch das Vorhandensein nur einer einzigen Gold-Schicht auf einer einzigen der beiden miteinander zu verbindenden Scheiben, wenn die Oberfläche der zweiten Scheibe oxidfrei gehalten wird, damit eine Gold-Silicium-Eutektikumsphase gebildet werden kann, über die dann die beiden miteinander zu verbindenden Scheiben miteinander verbunden werden.

Oxidfrei gehalten werden kann die Oberfläche einer Scheibe beispielsweise in einem Vakuum oder in einer speziellen oxidfreien Atmosphäre oder durch Aufbringen einer oder mehrerer anderer Schichten, welche die Bildung der Gold-Silicium-Eutektikumsphase nicht verhindern und somit die Verbindung der beiden Scheiben über diese Gold-Silicium-Eutektikumsphase ermöglichen.

Die Gold-Silicium-Eutektikumstemperatur ist derart niedrig, daß weniger mechanische Verspannungen der miteinander verbundenen Scheiben beim Abkühlen dieser Scheiben entstehen und daß die Drucksensormembranscheibe auch dann mit einer Trägerscheibe verbunden werden kann, wenn sie die für eine bestimmte Silicium-Technologie erforderlichen Schritte durchlaufen hat.

Weitere Vorteile und Ausgestaltungen der Erfindung ergeben sich aus den Unteransprüchen, der Beschreibung und der Zeichnung.

Die Erfindung ist am Beispiel der Herstellung von Drucksensor-Meßzellen im Wafer-Verband dargestellt.

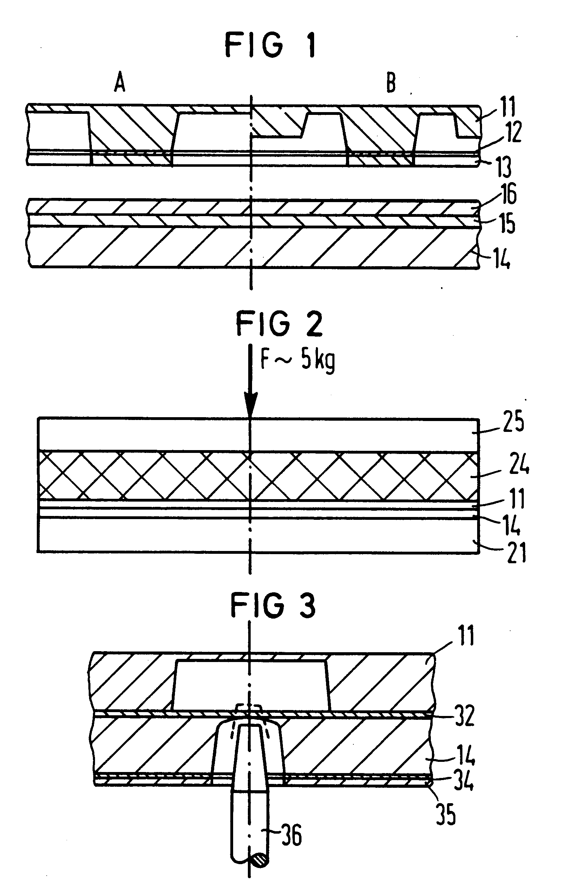

Die Figuren 1 bis 3 erläutern schematisch verschiedene Verfahrensschritte bei der Herstellung von Drucksensor-Meßzellen im Waferverband gemäß der Erfindung.

Figur 1 zeigt eine komplett fertiggestellte Drucksensormembranscheibe (Systemscheibe) 11, die bereits sämtliche für eine bestimmte Silicium-Technologie erforderlichen Verfahrensschritte durchlaufen hat. Insbesondere bedeutet dies, daß die Systemscheibe 11 bereits alle für diese Systemscheibe 11 erforderlichen pn-Übergänge zusammen mit den üblichen Leiterbahn-Verbindungen und zusammen mit den üblichen Passivierungsschichten aufweist. All diese Einzelheiten der bereits komplett fertiggestellten Systemscheibe 11 werden durch das im folgenden geschilderte Verfahren nicht in nachteilhafter Weise beeinträchtigt.

Nach Durchführung der Silicium-Planartechnik bei der Systemscheibe 11 wird auf die rauhe Oberfläche dieser Systemscheibe 11 zunächst eine dünne Titan-Schicht 12 als Haftvermittler für die auf diese Titan-Schicht 12 aufzubringende Gold-Schicht 13 aufgebracht. Die Titan-Schicht 12 ist so dünn, daß sie gerade ihre Haftvermittlungsfunktion ausüben kann. Beispielsweise ist die Titan-Schicht 12 25 nm dick. Die Gold-Schicht 13 ist so dick, daß sie als Ätzmaske zur Erzeugung der Drucksensormembran durch strukturiertes Ätzen der Rückseite der Systemscheibe 11 dienen kann. Beispielsweise hat die Gold-Schicht 13 eine Dicke von 600 nm. Die Figur 1 zeigt die Systemscheibe 11 nach der Strukturierung der Drucksensormembran. Im Teil A der Figur 1 ist eine Systemscheibe mit Kreismembranen und im Teil B der Figur 1 ist eine Systemscheibe 11 mit Kreisringmembranen dargestellt.

Die bereits komplett fertiggestellte Systemscheibe 11 wird mit einer Trägerscheibe 14 vakuumdicht, das bedeutet mit einer Leckrate von weniger als $10^{-9}$ mbar liter/sec ($10^{-7}$ Pa liter/sec), verbunden.

Zu dieser Gold-Legierungs-Verbindung wird im Ausführungsbeispiel einerseits die zur Drucksensor-Membranätzung ohnedies notwendige Titan-Gold-Ätzmaske 12, 13 und eine auf die Trägerscheibe 14 aufgebrachte Gold-Doppelschicht 15, 16 verwendet. Die Ätzmaske auf der Systemscheibe 11 besteht aus einem Zweischichtsystem 12, 13 mit 25 nm Titan und 600 nm Gold. Auf der Trägerscheibe 14 wird in einem ersten Schritt eine 1500 nm dicke Gold-Schicht 15 aufgebracht, die anschließend bei 420 °C auf die Trägerscheibe 14 auflegiert wird. In einem weiteren Beschichtungsschritt wird auf die kurz mit Flußsäure (HF) überätzte erste Gold-Schicht 15 eine weitere Gold-Schicht 16 mit ebenfalls 1500 nm Dicke aufgedampft. Es hat sich als zweckmäßig erwiesen, diese zweite Gold-Schicht 16 vor der Verbindung der beiden Scheiben 11, 14 miteinander nicht auf die Trägerscheibe 14 aufzulegieren, da nur durch besondere Maßnahmen wie z. B. durch waagrechte Lage der Halbleiterscheibe 14 starke Schichtdikkenunterschiede zu vermeiden wären. Diese besonderen Maßnahmen wären zwar prinzipell möglich, weisen jedoch Nachteile auf wie beispielsweise großen Platzbedarf bei der Herstellung.

Figur 2 erläutert ein vorteilhaftes Verfahren zur gleichzeitigen Verbindung von mehreren Scheiben miteinander in einem Stapel. Die beispielsweise entsprechend dem Ausführungsbeispiel nach Figur 1 vorpräparierten Systemscheiben 11 und Trägerscheiben 14 werden in einem entsprechenden Ofen unter Formiergas bzw. unter Vakuum in einem Stapel von zirka 25 Scheibenpaaren 11, 14 auf zirka 440 °C erhitzt und über die Gold-Silicium-Eutektikumsphase miteinander verbunden. Der Scheibenstapel kann mit einem Gewicht F von ca. 5 kg belastet werden. Die Scheibenpaare 11, 14 liegen jeweils auf einer stabilen Silicium-Scheibe 21 bzw. 25, die Druckübertragung zwischen den Einzelpositionen der jeweiligen Scheibenpaare 11, 14 erfolgt vorzugsweise über Quarzwollmatten 24 von einem Scheibenpaar 11, 14 auf das andere Scheibenpaar. Die Justierung von Trägerscheibe 14 und Systemscheibe 11 erfolgt über Scheibendurchmesser und Scheiben-Flat. Für die Zwischenscheiben 21, 25 kann zirka 3 mm dickes Silicium verwendet werden. Die Quarzwollmatten 24 sind vorzugsweise 10-15 mm dick. Bei der Herstellung von Absolutdruck-Sensoren mit einer Vakuum-Referenz bzw. mit einem bestimmten Referenzdruck werden Systemscheibe 11 und Trägerscheibe 14 in Vakuum oder bei einem entsprechenden Druck miteinander verbunden.

Für die Verbindung von Niederdrucksensoren (generell Relativ- bzw. Differenzdrucksensoren) wird die Legiertechnik unter Formiergas ausgeführt. Das Legierverfahren wird unter einem Formiergasdruck von beispielsweise 1-2 bar (100-200 kPa) bei 440 °C durchgeführt, so daß bei Raumtemperatur nach Abkühlung der miteinander verbundenen Scheiben 11, 14 unter Atmosphärendruck eine teilweise oder ganz entspannte Drucksensor-Membran vorliegt. Dieses Formiergasverfahren kann auch bei einem Gasdruck von einem bar (100 kPa) bei 440 °C in einem Durchlaufofen im Einzel-Herstellungsverfahren durchgeführt werden.

Speziell für Drucksensor-Meßzellen mit Ringmembranen wird die Mittelinsel in einer Zweistufenätztechnik gegenüber der Rückseite der Systemscheibe 11 um zirka 80-100 µm zurückgesetzt, um den Hub der Drucksensor-Membran unter Druck zu gewährleisten und um ein Anlegieren der Mittelinsel zu vermeiden. Zusätzlich werden durch das Zurücksetzen der Mittelinsel Justierprobleme beseitigt, die sich durch eine Freistellung der Mittelinsel mit Hilfe einer Strukturierung der Trägerscheibe 14 ergeben würden.

Figur 3 zeigt schematisch zwei mit Hilfe einer Gold-Silicium-Eutektikumsphase 32 verbundene Silicium-Scheiben, nämlich die Systemscheibe 11 und die Trägerscheibe 14.

Die in Figur 3 dargestellten Systemscheibe 11 und Trägerscheibe 14 sollen im Ausführungsbeispiel für eine Relativdruck-Meßzelle verwendung finden. Zu diesem Zweck wird die Rückseite der Trägerscheibe 14 mit einer Ätzmaske, bestehend zunächst aus einer Titan-Schicht 34 von 25 nm Dicke und darüber eine Gold-Schicht 35 mit einer Dicke von 600 nm versehen, die später auch zur Montage der Relativdruck-Meßzelle, d. h. zur Auflötung der Relativdruckmeßzelle auf ein Gehäuse, dienen kann. Um die für die Relativdruck-Meßzelle erforderliche Ausgleichsbohrung herzustellen, wird die Titan-Gold-Ätzmaske 34, 35 mit einer entsprechenden Fototechnik strukturiert und wird sodann die Trägerscheibe 14 von der Rückseite her geätzt. Hierbei fungiert die eutektische Gold-Silicium-Schicht 32, die die die Systemscheibe 11 mit der Trägerscheibe 14 verbindende Gold-Silicium-Eutektikumsphase darstellt, als Ätzstop. Diese eutektische Gold-Silicium-Schicht 32 ist bei einem Herstellungsverfahren nach Figur 1 noch zirka 3 $\mu$m dick. Diese eutektische Gold-Silicium-Schicht 32 wird zur Erzeugung der Ausgleichsbohrung nach der Ätzung der Trägerscheibe 14 mechanisch mit Hilfe einer Durchstoßnadel 36 durchgestoßen. Vorteilhafterweise können sämtliche Bohrungen eines mit mehreren Relativdruck-Meßzellen versehenen Wafer mit einem Nadel-Igel in einem einzigen Arbeitsgang durchgestoßen werden. Bei unter Vakuum legierten Absolutdruck-Meßzellen entfallen die zur Erzeugung der Ausgleichsbohrung dargestellten Fertigungsschritte. Bei unter Vakuum legierten Absolutdruck-Meßzellen wird lediglich die Rückseitenbeschichtung der Trägerscheibe 14 mit einer Titan-Gold-Doppelschicht 34, 35 durchgeführt und nach Bedarf eine Ringnut geätzt, die zum Abbau mechanischer Spannungen, die beispielsweise aufgrund der Montage entstehen können, dient.

Bezugszeichenliste

| | | |
|---|---|---|
| 11 | = | Systemscheibe |
| 12 | = | Titan-Schicht |
| 13 | = | Gold-Schicht |
| 14 | = | Trägerscheibe |
| 15, 16 | = | Gold-Doppelschicht |
| 21 | = | Silicium-Scheibe |
| 24 | = | Quarzwollmatten |
| 25 | = | Silicium-Scheibe |
| 32 | = | Gold-Silicium-Eutektikumsphase |
| 34 | = | Titan-Schicht |
| 35 | = | Gold-Schicht |
| 36 | = | Durchstoßnadel |

**Patentansprüche**

1. Verfahren zur Herstellung eines Drucksensors **dadurch gekennzeichnet,** daß auf eine Träger-Scheibe aus Silizium (14) eine Gold-Schicht (15) auflegiert wird, daß die Oberfläche einer Drucksensormembran-Scheibe aus Silizium (11) Silizium-Oxid-frei gehalten wird, und daß die beiden Silizium-Scheiben (11, 14) unter Formiergas oder Vakuum auf eine Temperatur oberhalb der Gold-Silizium-Eutektikumstemperatur erhitzt werden und über die Gold-Silizium-Eutektikumsphase (32) verbunden werden.

2. Verfahren nach Anspruch 1, **dadurch gekennzeichnet,** daß auf die beiden Scheiben (11, 14) bei einer Temperatur oberhalb der Gold-Silizium-Eutektikumstemperatur ein Druck (F) ausgeübt wird.

3. Verfahren nach Anspruch 1 oder 2, **dadurch gekennzeichnet,** daß auf die Träger-Scheibe (14) eine erste Gold-Schicht (15) auflegiert und auf die erste Gold-Schicht (15) eine zweite Gold-Schicht (16) aufgedampft wird.

4. Verfahren nach einem der Ansprüche 1 bis 3, **dadurch gekennzeichnet,** daß auf die Membran-Scheibe (11) eine Schicht (13) aufgebracht wird, die mit Gold verbindbar ist.

5. Verfahren nach Anspruch 4, **dadurch gekennzeichnet,** daß auf die Membran-Scheibe (11) eine Gold-Schicht (13) aufgebracht wird.

6. Verfahren nach Anspruch 4 oder 5, **dadurch gekennzeichnet,** daß auf die Membran-Scheibe (11) eine Schicht (12) zur Haftvermittlung zwischen der Silizium-Scheibe (11) und einer Gold-Schicht (13) und auf diese Schicht (12) eine Gold-Schicht (13) aufgebracht wird.

7. Verfahren nach einem der Ansprüche 1 bis 6, **dadurch gekennzeichnet,** daß eine der Schichten (12, 13, 15, 16) auf eine rauhe Oberfläche einer Silizium-Scheibe (11, 14) aufgebracht wird.

8. Verfahren nach einem der Ansprüche 1 bis 7, **dadurch gekennzeichnet,** daß Scheibenpaare (11, 14) stapelweise über die Gold-Silizium-Eutektikumphase (32) miteinander verbunden werden.

9. Verfahren nach Anspruch 8,

**dadurch gekennzeichnet,** daß zu verbindende Scheibenpaare (11, 14) mit Hilfe von Quarz- wollmatten (24) übereinander gestapelt wer- den.

10. Verfahren zur Herstellung eines Drucksensors **dadurch gekennzeichnet,** daß eine Drucksensormembran-Scheibe (11) aus Silizium mit einer Gold-Schicht (13) versehen wird oder oxidfrei gehalten wird und daß eine Träger-Scheibe (14) aus Silizium mit einer Gold-Schicht (15) versehen wird, daß die beiden Scheiben (11, 14) unter Formiergas oder Vakuum auf eine Temperatur oberhalb der Gold-Silizium-Eutektikumstemperatur erhitzt werden und über die Gold-Silizium-Eutekti- kumsphase (32) miteinander verbunden wer- den.

**Claims**

1. Method of producing a pressure sensor, characterised in that a gold layer (15) is alloyed onto a silicon substrate wafer (14), in that the surface of a silicon pressure sensor membrane wafer (11) is kept free of silicon oxide, and in that the two silicon wafers (11, 14) are heated under forming gas or in a vacuum to a temperature above the gold/silicon eutectic temperature and are bonded by means of the gold/silicon eutectic phase (32).

2. Method according to Claim 1, characterised in that a pressure (F) is applied to the two wafers (11, 14) at a temperature above the gold/silicon eutectic temperature.

3. Method according to Claim 1 or 2, characterised in that a first gold layer (15) is alloyed onto the substrate wafer (14) and a second gold layer (16) is vapour-deposited on the first gold layer (15).

4. Method according to one of Claims 1 to 3, characterised in that a layer (13) which can be bonded to gold is deposited on the membrane wafer (11).

5. Method according to Claim 4, characterised in that a gold layer (13) is deposited on the membrane wafer (11).

6. Method according to Claim 4 or 5, characterised in that an adhesion promotion layer (12) is deposited on the membrane wafer (11) between the silicon wafer (11) and a gold layer (13) and a gold layer (13) is deposited on said layer (12).

7. Method according to one of Claims 1 to 6, characterised in that one of the layers (12, 13, 15, 16) is deposited on a rough surface of a silicon wafer (11, 14).

8. Method according to one of Claims 1 to 7, characterised in that the pair of wafers (11, 14) are bonded to each other as a stack by means of the gold/silicon eutectic phase (32).

9. Method according to Claim 8, characterised in that the pair of wafers (11, 14) to be bonded are stacked on top of each other with the aid of quartz wool mats (24).

10. Method of producing a pressure sensor characterised in that a silicon pressure sensor membrane wafer (11) is provided with a gold layer (13) or is kept free of oxide, in that a silicon substrate wafer (14) is provided with a gold layer (15), and in that the two wafers (11, 14) are heated under forming gas or a vacuum to a temperature above the gold/silicon eutectic temperature and are bonded to each other by means of the gold/silicon eutectic phase (32).

**Revendications**

1. Procédé pour fabriquer un capteur de pression, caractérisé par le fait qu'on fixe par alliage une couche d'or (15) sur un disque de support en silicium (14), qu'on maintient exempte d'oxyde de silicium la surface d'un disque-membrane en silicium (11) du capteur de pression et qu'on chauffe les deux disques de silicium (11,14) en utilisant un gaz de formage ou bien sous vide, à une température supérieure à la température de l'eutectique or- silicium et qu'on les réunit par l'intermédiaire de la phase eutectique or-silicium (32).

2. Procédé suivant la revendication 1, caractérisé par le fait qu'on applique une pression (F) aux deux disques (11,14) à une température supérieure à la température de l'eutectique or-silicium.

3. Procédé suivant la revendication 1 ou 2, caractérisé par le fait qu'on fixe par alliage une première couche d'or (15) sur le disque de support (14) et qu'on dépose par évaporation une seconde couche d'or (16) sur la première couche d'or (15).

4. Procédé suivant l'une des revendications 1 à 3, caractérisé par le fait qu'on dépose sur le disque-membrane (11) une couche (13) que l'on peut relier à de l'or.

5. Procédé suivant la revendication 4, caractérisé par le fait qu'on dépose une couche d'or (13) sur le disque-membrane (11).

6. Procédé suivant la revendication 4 ou 5, caractérisé par le fait qu'on dépose sur le disque-membrane (11) une couche (12) destinée à faire adhérer entre eux le disque en silicium et une couche (12) d'or (13) et qu'on dépose une couche d'or (13) sur cette couche (12).

7. Procédé suivant l'une des revendications 1 à 6, caractérisé par le fait qu'on dépose l'une des couches (12,13,15,16) sur une surface rugueuse d'un disque de silicium (11,14).

8. Procédé suivant l'une des revendications 1 à 7, caractérisé par le fait qu'on raccorde entre eux les deux disques (11,14), à l'état empilé, par l'intermédiaire de la phase eutectique or-silicium (32).

9. Procédé suivant la revendication 8, caractérisé par le fait qu'on superpose deux couples de disques (11,14) devant être réunis, au moyen d'un matelas de laine de quartz (24).

10. Procédé pour fabriquer un capteur de pression caractérisé par le fait qu'on applique une couche d'or (13) sur un disque en silicium (11) formant membrane du capteur de pression ou qu'on maintient ce disque exempt d'oxyde et qu'on dépose une couche d'or (15) sur un disque de support (14) en silicium, qu'on chauffe les deux disques (11,14) en présence d'un gaz de formage ou sous vide, à une température supérieure à la température de l'eutectique or-silicium et qu'on les réunit l'un à l'autre par l'intermédiaire de la phase (32) de l'eutectique or-silicium.

# FIG 1

A            B

11
12
13

16
15
14

# FIG 2

F ~ 5kg

25
24
11
14
21

# FIG 3

11

32

14
34
35

36